# EUROPEAN PATENT SPECIFICATION

(11) **EP 3 537 529 B1**
(45) Date of publication and mention of the grant of the patent: **16.02.2022**
(21) Application number: 17867927.0
(22) Date of filing: 30.08.2017
(51) Int. Cl.: H01M 10/42, B60R 16/04, G01R 31/36, H01M 10/48, H02J 7/00

(54) **CONTROL DEVICE**
STEUERUNGSVORRICHTUNG
DISPOSITIF DE COMMANDE

(30) Priority: 02.11.2016 JP 2016214833
(43) Date of publication of application: 11.09.2019
(73) Proprietor: Bosch Corporation, Tokyo 150-8360 (JP)
(72) Inventor: YAMADA Tetsuya, Yokohama-shi Kanagawa 224-8501 (JP)
(74) Representative: Bee, Joachim
(86) International application number: PCT/JP2017/031142
(87) International publication number: WO 2018/083873

(56) References cited:
- CN-A- 101 639 522
- JP-A- 2006 188 130
- JP-A- 2006 509 670
- JP-A- 2007 280 776
- JP-A- 2010 064 538
- JP-A- 2010 208 539
- JP-A- 2010 221 948
- JP-A- 2010 230 654

## Description

### Technical Field

The present invention relates to a control device capable of determining deterioration of a secondary battery.

### Background Art

Conventionally, in an automobile, an alternator generates electric power all the time by using rotation of an engine as a power source. Thus, even after a battery is fully charged, a load is applied to the engine, and fuel is consumed.

In recent years, a system that does not directly drive the engine or the alternator (does not generate the electric power all the time), uses the electric power stored in the battery when possible (discharges the electric power), and causes rotation of the alternator to charge the battery before the battery reaches an over-discharge level for a purpose of improving fuel consumption has become popularized. This is a harsher use environment for the battery than before, a possibility of battery deterioration is increased more than before, and acknowledgement of the battery deterioration becomes more important than before. However, an end user intuitively determines auxiliary charging or replacement timing to a new product by himself/herself when noticing a problem of the battery such as poor startability or dim headlights. For such a reason, a demand for determining the deterioration of the battery mounted on the automobile by using a system has been increased.

In general, when the battery is deteriorated, an internal resistance value of the battery is increased, which hinders an electrical current. For example, deterioration of a vehicle lead battery can accurately be determined by measuring a cold cranking amps (CCA) value (a discharge current at 7.2 V after 30 seconds with a fluid temperature at -18°C), specific gravity of dilute sulfuric acid, or a charge/discharge current by a dedicated sensor. A configuration of newly providing the dedicated sensor, just as described, is simple as means for solving the problem. However, for the vehicle in which various restrictions are imposed on a mounting space of a component, there are problems that addition of a new component is unrealistic and that addition of an inspection process increases a product price. In regard to this point, a battery voltage is already measured by an engine control unit (ECU) or the like, and the dedicated sensor does not have to be newly provided. Thus, in existing circumstances, the battery deterioration is mostly determined on the basis of the battery voltage in a steady state.

Here, in the case where the battery is deteriorated, internal resistance is often increased (clearly appears in the lead battery, for example). In addition, at a start of the engine, a large current is momentarily demanded by a starter motor. Thus, at the start of the engine, a voltage drop caused by such increased internal resistance appears remarkably. In view of such a characteristic, measuring the lowest point of the battery voltage at the start of the engine to determine the battery deterioration is disclosed (see PTL 1).

CN-A-101 639 522 (PTL 2) describes an equipment for diagnosing degradation state of a secondary battery, wherein minimum voltage detection operation is performed, the minimum voltage value is studied after beginning to use the secondary battery, and the degradation state of the secondary battery can be diagnosed according to the detected minimum voltage and an original minimum voltage value.

### Citation List

### Patent Literature

PTL 1: JP-A-2010-208539
PTL 2: CN-A-101 639 522

### Summary of Invention

### Technical Problem

In order to accurately monitor the lowest point of the battery voltage, sampling intervals have to be shortened. In general, for example, 10 to 20 ms of the sampling intervals of the battery voltage used in the system suffice. However, in order to monitor the lowest point at the start of the engine with satisfactory accuracy, shorter sampling intervals, such as of several ms, are necessary. However, continuation of sampling at this rate all the time has a problem of an unnecessary calculation load imposed on a central processing unit (CPU).

The present invention has been made in view of the above points and therefore proposes a control device capable of determining deterioration of a secondary battery with a high degree of accuracy without adding a new sensor or setting extraction intervals of a voltage value to be shorter than existing intervals.

### Solution to Problem

In order to solve such a problem, the present invention provides a control device according to claim 1.

According to the control device of the present invention, when the extraction processing is executed at every second interval, the plural voltage values measured at the first intervals are acquired and evaluated. In this way, the lowest point of the battery voltage at the start of the engine is measured with a high degree of accuracy. Therefore, the deterioration of the secondary battery can be determined with the high degree of accuracy.

### Advantageous Effects of Invention

The present invention can provide the control device capable of determining the deterioration of the secondary battery with the high degree of accuracy without adding a new sensor or setting the extraction intervals of the voltage value to be shorter than the existing intervals.

### Brief Description of Drawings

Fig. 1 is a block diagram illustrating a schematic configuration of a vehicle system.
Fig. 2 is a view illustrating a schematic configuration of sampling in an ECU.
Fig. 3A is a flowchart of processing executed by the ECU.
Fig. 3B is a flowchart of the processing executed by the ECU.
FIG. 4 is a graph illustrating a detection result of the lowest point.

### Description of Embodiments

A detailed description will hereinafter be made on an embodiment of the present invention with reference to the drawings.

### (1) Embodiment

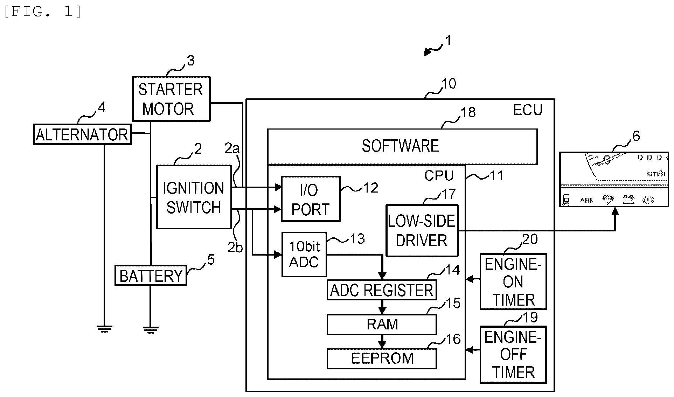

Fig. 1 illustrates a schematic configuration of a vehicle system 1 according to this embodiment. This vehicle system 1 is configured to include an ignition switch 2, a starter motor 3, an alternator 4, a battery 5, an indicator lamp and warning lamp panel 6, and an ECU 10. In this vehicle system 1, when the ignition switch 2 is turned on and an internal combustion engine start signal (a starter signal 2a) is further turned on, the starter motor 3 rotates by using electric power of the battery 5 as a secondary battery (for example, a lead battery), and an engine (not illustrated) as an internal combustion engine is started. At a start of the engine, the ECU 10 determines whether the battery 5 is deteriorated (battery deterioration determination processing). In the case where the battery 5 is deteriorated, a function of notifying a driver of abnormality of the battery 5 can be provided by lighting a warning lamp, which indicates the deterioration of the battery 5, on the indicator lamp and warning lamp panel 6.

Here, the ECU 10 is a control device mounted on an automobile or the like, includes a CPU 11, an engine-off timer 19, and an engine-on timer 20, and executes control of electrical components, the battery deterioration determination processing, and the like. In addition, the CPU 11 includes an I/O port 12, a 10 bit analog-to-digital converter (ADC) 13, an ADC register 14, random access memory (RAM) 15, Electrically Erasable Programmable Read-Only Memory (EEPROM) 16, a low-side driver 17, and the like. Note that the above-described hardware configuration is an example. The control (the processing) executed by the ECU 10 may partially or entirely be executed by hardware (a circuit and the like) or may be executed by software 18 (for example, reading a program stored in ROM (not illustrated) by the CPU 11).

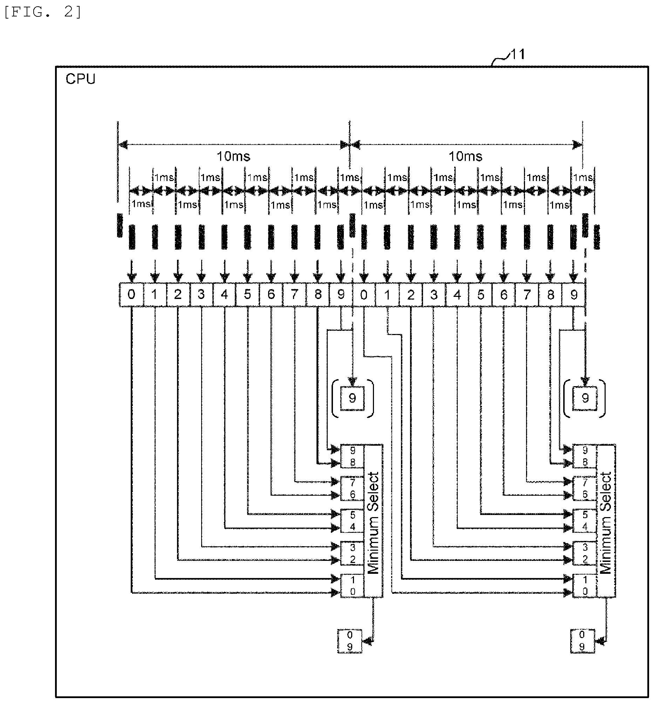

As illustrated in Fig. 2, the ADC 13 reads a signal (a sensor signal) of a sensor that measures a voltage in the battery 5 (a battery voltage) at every 1 ms and stores the signal as digital data (a voltage value) in the ADC register 14. For example, in the case where a sampling interval by the CPU 11 (an interval in which the CPU 11 extracts the voltage value from the ADC register 14) is set at 10 ms for a purpose of identifying the lowest point of the battery voltage at the start of the engine, the last voltage value saved in the ADC register 14 is conventionally used, and the nine voltage values of the ten voltage values are unused. In regard to this point, the further accurate data (lowest point of the battery voltage) can be extracted by shortening the sampling interval by the CPU 11 to 2 ms. However, the short sampling interval, such as of 2 ms, imposes a calculation load on the CPU 11, and thus the sampling interval by the CPU 11 at usual 10 to 20 ms is the appropriate sampling interval. In view of this, the ECU 10 in this embodiment adopts such a configuration that a processing rate of the ADC 13 (a measurement interval) "1 ms" and a processing rate (the sampling interval) of the CPU 11 "10 ms" are not changed and that the CPU 11 determines the lowest point (the lowest value) based on ten values of the data, which are output from the ADC 13, in the ADC register 14 at every sampling interval of the CPU 11 and saves the lowest point in the RAM 15. In regard to the lowest point, the CPU 11 may set the lowest voltage value of the ten values of the data in the ADC register 14 as the lowest point. However, the CPU 11 averages the two successive values of the data and selects the lowest average value of five average values of the data (average values) as the lowest point. Just as described, noise can be eliminated from the sensor signals by selecting the lowest point from the average values.

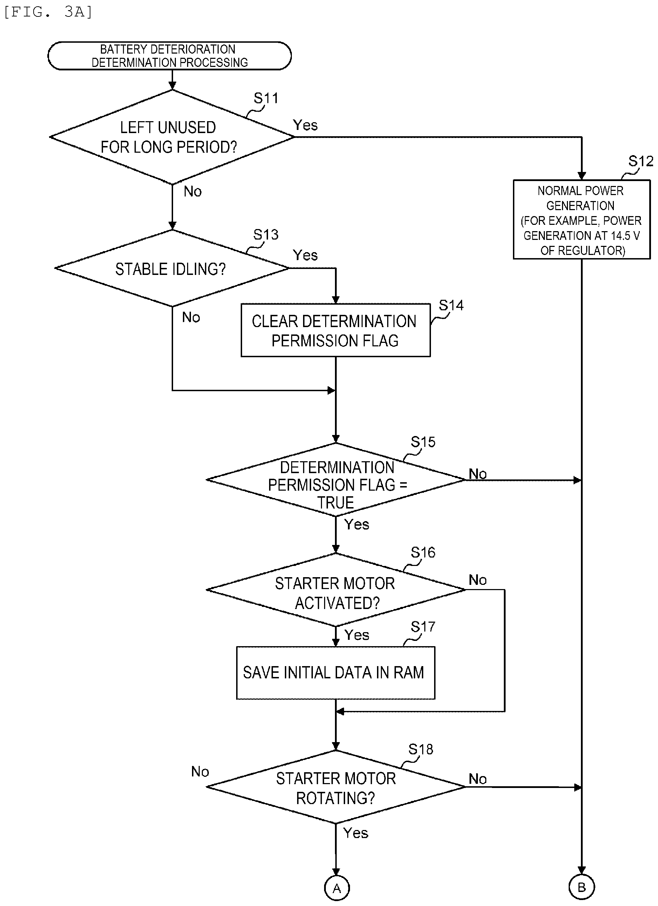

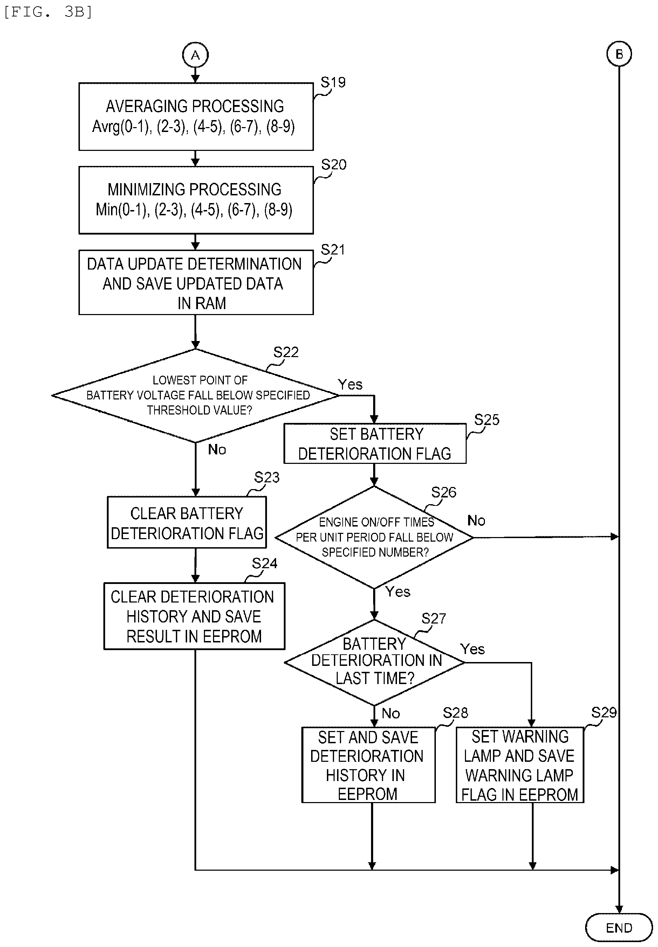

Next, a description will be made on the battery deterioration determination processing, which is executed by the ECU 10 at every 10 ms, on the basis of flowcharts illustrated in Fig. 3A and Fig. 3B. Repetition of the battery deterioration determination processing is initiated in accordance with an appropriate user operation before the start of the engine, such as accessory position ON or key ON, and is terminated when a preset termination condition such as idling stabilization or a rotation stop of the starter motor 3 is satisfied.

First, in step S11, the ECU 10 determines whether a vehicle is left unused for a long period, more specifically, whether the engine-off timer 19 is equal to or longer than a specified time (S11). If the ECU 10 determines that the vehicle is left unused for the long period, the battery 5 is possibly overdischarged. Thus, the ECU 10 does not identify (detect) the lowest point in a current driving cycle, and the electric power is normally generated (S12). Then, the ECU 10 terminates the battery deterioration determination processing. On the other hand, if it is determined that the vehicle is not left unused for the long period, the processing proceeds to step S13.

Here, in the current vehicle system, the slight electric power continues flowing (a dark current) even during key OFF. Thus, as a period in which the vehicle is left unused (the engine is not started) extends, the battery is brought into a discharged state. However, this is not battery deterioration but merely running out of the battery (near empty). For example, even when a dedicated sensor is newly attached, it is difficult to detect running out of the battery, which is discharged by the dark current. Thus, in the case where the lowest point of the battery voltage of the battery 5 that is overdischarged by being left unused is determined in a similar manner, erroneous detection occurs. For this reason, a diagnosis is skipped during first driving after the vehicle is left unused for the long period. Note that whether the over-discharge occurs can be estimated from an amount of the current used in the vehicle system.

Next, in step S13, the ECU 10 determines whether idling is stable, more specifically, whether an idling delay timer exceeds a specified time (S13) . If the ECU 10 determines that idling is stable, the ECU 10 clears a determination permission flag so as to terminate the battery deterioration determination processing (S14), and the processing proceeds to step S15. That is, the lowest point of the battery voltage becomes predominant at the start of the engine. After a speed of the engine becomes stable and the electric power of the alternator 4 can be used, the lowest point of the battery voltage can no longer detected. Thus, the battery deterioration determination processing is stopped when the speed of the engine becomes stable. On the other hand, if the ECU 10 determines that the idling is not stable, the processing proceeds to step S15, and the battery deterioration determination processing continues until the specified time in S13 elapses.

Next, in step S15, the ECU 10 determines whether the determination permission flag is "TURE", that is, whether to detect the lowest point of the battery voltage (S15) . If the ECU 10 determines to detect the lowest point of the battery voltage, the processing proceeds to step S16. If the ECU 10 determines not to detect the lowest point of the battery voltage, the battery deterioration determination processing is terminated. Note that an initial value "TURE" is set for the determination permission flag in initialization processing (not illustrated) of the battery deterioration determination processing.

Next, in step S16, the ECU 10 determines whether the starter motor 3 is started (S16). A value of the RAM 15 (a RAM value) indicating the lowest point of the battery voltage is "0" during initial activation of the starter motor 3. Thus, if the ECU 10 determines that the starter motor 3 is started, the ECU 10 saves an initial value (for example, 12 V) of the lowest point of the battery voltage in the RAM 15 (S17), and the processing proceeds to step S18. If the ECU 10 determines that the starter motor 3 is not started, the processing proceeds to step S18.

Next, in step S18, the ECU 10 determines whether the starter motor 3 is rotating (S18). If the ECU 10 determines that the starter motor 3 is rotating, the processing proceeds to step S19. If the ECU 10 determines that the starter motor 3 is not rotating, the battery deterioration determination processing is terminated.

Next, in step S19, the ECU 10 executes averaging processing of the voltage values in the ADC register 14 (S19) . More specifically, the ECU 10 generates averaged data (an average value (0-1), an average value (2-3), an average value (4-5), an average value (6-7), an average value (8-9)) by calculating an average of two each of the successive voltage values of the ten voltage values saved in the ADC register 14.

Next, in step S20, the ECU 10 executes minimum processing of the averaged data (S20). More specifically, the ECU 10 identifies the lowest average value of the averaged data.

Next, in step S21, the ECU 10 updates the lowest point of the battery voltage (S21) . More specifically, the ECU 10 compares the lowest average value identified in step S20 (the current lowest point) and the saved value in the RAM 15 (the previous lowest point). Then, in the case where the current lowest point is lower than the previous lowest point, the ECU 10 updates the value in the RAM 15 to the current lowest point.

Next, in step S22, the ECU 10 determines whether the lowest point of the battery voltage falls below a specified threshold value (for example, whether equal to or lower than 7.2 V) (S22) . If the ECU 10 determines that the lowest point of the battery voltage falls below the specified threshold value, the processing proceeds to step S25. If the ECU 10 determines that the lowest point of the battery voltage does not fall below the specified threshold value, the processing proceeds to step S23.

Next, in step S23, the ECU 10 clears a battery deterioration flag that indicates the deterioration (abnormality) of the battery 5 (S23) . Then, in step S24, the ECU 10 clears history that indicates the deterioration of the battery 5 in the current driving cycle (deterioration history) from the EEPROM 16 (S24), and terminates the battery deterioration determination processing.

Next, in step S25, the ECU 10 sets the battery deterioration flag to "TURE" (S25), and the processing proceeds to step S26.

Next, in step S26, the ECU 10 determines whether the number of ON and OFF of the engine per unit period fall below specified number, more specifically, whether the engine-on timer 20 exceeds a prescribed time (S26). If the ECU 10 determines that the number of ON and OFF of the engine per unit period falls below the specified number (determines that the engine-on timer 20 exceeds the prescribed time), the processing proceeds to step S27. If the ECU 10 determines that the number of ON and OFF of the engine per unit period does not fall below the specified number (determines that the engine-on timer 20 does not exceed the prescribed time), the battery deterioration determination processing is terminated. Here, a value of the engine-on timer 20 is saved in the EEPROM 16 in the last driving cycle. The small value of the engine-on timer 20 does not indicate normal use but indicates that the battery 5 is discharged significantly. Thus, such a case is not considered as the battery deterioration. More specifically, in the case where the vehicle used for a parcel delivery service or the like repeatedly moves and stops in a short period, the value of the engine-on timer 20 is small, and there is a possibility that the battery deterioration cannot be determined correctly. Thus, the determination of the battery deterioration is skipped. Meanwhile, in the case where the vehicle is not used for the parcel delivery service and uses a large amount of the electric power (energy) of the battery 5, the value of the engine-on timer 20 is not sufficiently increased as described later, and there is the possibility that the battery deterioration cannot be determined correctly. Thus, the determination of the battery deterioration is skipped. However, in the case where the vehicle is not used for the parcel delivery service and does not use the large amount of the electric power of the battery 5, the value of the engine-on timer 20 is sufficiently increased. Thus, the determination of the battery deterioration is made.

Next, in step S27, the ECU 10 refers to the last deterioration history that is saved in the EEPROM 16, and determines whether it is determined that the battery 5 is deteriorated in the last driving cycle (S27). If the ECU 10 determines that the battery 5 is deteriorated (for example, determines two times in a row that the battery 5 is deteriorated), the processing proceeds to step S29. If the ECU 10 determines that the battery 5 is not deteriorated, the processing proceeds to step S28.

Here, in the vehicle system 1 according to this embodiment, the ECU 10 or the like measures ON signals of components, each of which consumes the large amount of the electric power (for example, headlamps, a glow plug, a positive temperature coefficient (PTC) heater, and the like), and also measures the value of the engine-on timer 20 (an engine ON time) . However, when the large amount of the energy of the battery 5 is used, there is a possibility that the battery 5 is not charged sufficiently. Thus, the engine ON time is not added. From this, even in the case where the engine ON time is insufficient and where the battery deterioration is successively detected, the ECU 10 does not determine that the battery 5 is deteriorated.

Next, in step S28, the ECU 10 sets the deterioration history in the EEPROM 16 (S28), and terminates the battery deterioration determination processing.

Next, in step S29, the battery deterioration is confirmed. Thus, the ECU 10 sets a warning lamp flag, which is used to light the warning lamp indicating the battery deterioration on the indicator lamp and warning lamp panel 6, in the EEPROM 16 (S29), and terminates the battery deterioration determination processing.

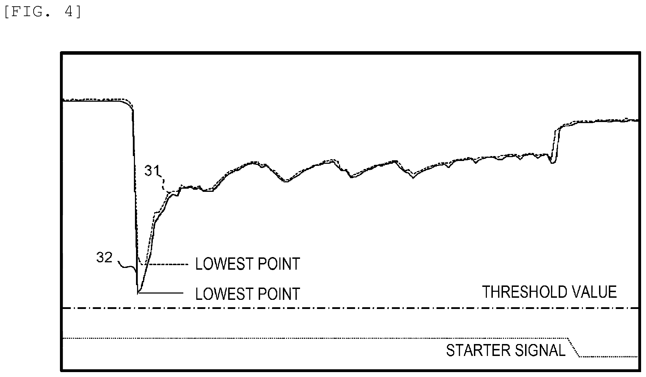

FIG. 4 is a graph illustrating a measurement result of the lowest point. In Fig. 4, a measurement result 31 is a result at the time when the single voltage value is extracted at every 10 ms and plotted, and a measurement result 32 is a result at the time when the averaging processing and the minimum processing are executed at every 10 ms and plotted. As illustrated in Fig. 4, it is understood that the lowest point is more accurately acquired when the averaging processing and the minimum processing are executed.

As it has been described so far, according to this embodiment, the ECU 10 capable of accurately measuring the lowest point of the battery voltage at the start of the engine can be provided without causing an increase in a required space for addition of a new sensor or the like and without reducing the load (the sampling intervals of the voltage value) of the CPU 11. In addition, the ECU 10 can promptly detect the deterioration and the over-discharge of the battery 5. Therefore, a trouble caused by running out of the battery can be prevented.

### (2) Other Embodiments

Note that the description has been made on the case where the present invention is applied to the ECU 10 mounted on the automobile or the like in the above-described embodiment; however, the present invention is not limited thereto and can widely be applied to various control devices. In particular, the present invention is favorably applied to the control devices mounted on the vehicles in each of which the battery is overused, such as the automobile including deceleration energy regeneration system, an automobile including an alternator having a C-terminal (a regulated voltage switching function), and a hybrid vehicle. For example, in the case where it is determined that a state of charge of the battery 5 is sufficient, the alternator having the C-terminal generates a minimum amount of the electric power or does not generate the electric power, and the electric power of the battery 5 is used. Thus, there is a possibility that the battery deterioration is enhanced. For this reason, it is favorable to apply the present invention to the automobile including the alternator having the C-terminal.

In the above-described embodiment, the description has been made on the case where the lowest point of the battery voltage is detected only once in the single driving cycle. However, the present invention is not limited thereto. Because there is a case where an engine stall occurs at the start of the engine, the lowest point of the battery voltage may be detected for plural times in the single driving cycle. For example, a configuration that allows to select an optional function (set a redetermination permission flag) may be adopted, so as to allow the lowest point of the battery voltage to be detected again.

In the above-described embodiment, the description has been made on the example in which the stop of the rotation of the starter motor 3 is set as the termination condition of the repetition of the battery deterioration determination processing. However, the present invention is not limited thereto. The termination condition may be set such that the battery deterioration determination processing is repeated even when the starter motor 3 is stopped. There is a case where the significant amount of the electric power of the battery 5 is used when a gear of the starter motor 3 is disengaged from a gear of the engine. However, according to this termination condition, it is possible to acknowledge a voltage drop caused by internal resistance at the time.

In the above-described embodiment, the description has been made on the case where, if the determination is Yes in step S22, the processing in step S25 is executed. However, the present invention is not limited thereto. Before the processing in step S25, it may be determined whether the lowest point of the battery voltage is 0 V. Then, if the lowest point of the battery voltage is 0 V, the battery deterioration determination processing may be continued.

In the above-described embodiment, the description has been made on the case where the battery deterioration determination processing is repeated at every 10 ms. However, the present invention is not limited thereto. The sampling interval by the ECU 10 may be set at 10 ms, and the other processing (the averaging processing, the minimum processing, the determination on whether the lowest point of the battery voltage falls below the specified threshold value, and the like) may be executed at appropriate timing.

### Reference Signs List

- 1:: Vehicle system
- 2:: Ignition switch
- 3:: Starter motor
- 4:: Alternator
- 5:: Battery
- 6:: Indicator lamp and warning lamp panel
- 10:: ECU
- 11:: CPU
- 12:: I/O port
- 13:: ADC
- 14:: ADC register
- 15:: RAM
- 16:: EEPROM
- 17:: Low-side driver
- 18:: Software
- 19:: Engine-off timer
- 20:: Engine-on timer

## Claims

1. A control device (10) that is configured to measure voltage values of a secondary battery (5) at first intervals and extract the lowest voltage value from the measured voltage values at a second interval that is longer than the first interval, at a start of an internal combustion engine, the control device (10) comprising:
a control unit (11, 18) that is configured to
repeat extraction processing to extract the lowest voltage value from the plural voltage values measured at the first intervals during the second interval comprising the plurality of the first intervals at every second interval, and specify the extracted lowest voltage value as the lowest voltage point of the secondary battery (5), and
battery deterioration determination processing to determine deterioration of the secondary battery (5) on the basis of whether the lowest voltage point falls below a threshold value, wherein the secondary battery (5) is determined not to be deteriorated if the lowest voltage point does not fall below the threshold value.

2. The control device according to claim 1, wherein
the control unit (11, 18) is configured to calculate an average of plural successive voltage values among the plural voltage values measured at the first intervals during the second interval at every second interval to specify the average values and extract the lowest average value among the specified average values as the lowest voltage value in the extraction processing.

3. The control device according to claim 1, wherein
the control unit (11, 18) is configured not to execute the extraction processing when determining that a time of an engine-off timer (17) is equal to or longer than a specified time at the start of the internal combustion engine.

4. The control device according to claim 1, wherein
the control unit (11, 18) is configured not to execute the extraction processing when an idling of the internal combustion engine is stable.

5. The control device according to claim 1, wherein
the control unit (11, 18) is configured to determine the deterioration of the secondary battery (5) when determining that an engine-on timer (20) exceeds a prescribed time.

## Patentansprüche

1. Steuerungsvorrichtung (10), die ausgelegt ist zum Messen von Spannungswerten einer Sekundärbatterie (5) in ersten Intervallen und Extrahieren des niedrigsten Spannungswerts aus den gemessenen Spannungswerten bei einem zweiten Intervall, das länger ist als das erste Intervall, bei einem Start eines Verbrennungsmotors, wobei die Steuerungsvorrichtung (10) umfasst:
eine Steuerungseinheit (11, 18), die ausgelegt ist zum
wiederholten Extrahierungsverarbeiten zum Extrahieren des niedrigsten Spannungswerts aus den mehreren Spannungswerten gemessen mit den ersten Intervallen während des zweiten Intervalls umfassend die mehreren der ersten Intervalle bei jedem zweiten Intervall, und Spezifizieren des extrahierten niedrigsten Spannungswerts als den untersten Spannungspunkt der Sekundärbatterie (5), und
Batterieverschlechterungsbestimmungsverarbeitung zum Bestimmen einer Verschlechterung der Sekundärbatterie (5) auf Basis dessen, ob der unterste Spannungspunkt unter einen Schwellwert fällt, wobei die Sekundärbatterie (5) als nicht verschlechtert bestimmt wird, falls der niedrigste Spannungspunkt nicht unter den Schwellwert fällt.

2. Steuerungsvorrichtung nach Anspruch 1, wobei
die Steuerungseinheit (11, 18) ausgelegt ist zum Berechnen eines Mittelwerts von mehreren aufeinanderfolgenden Spannungswerten unter den mehreren Spannungswerten gemessen mit den ersten Intervallen während des zweiten Intervalls bei jedem zweiten Intervall zum Spezifizieren der Mittelwerte und Extrahieren des niedrigsten Mittelwerts unter den spezifizierten Mittelwerten als der niedrigste Spannungswert in der Extraktionsverarbeitung.

3. Steuerungsvorrichtung nach Anspruch 1, wobei
die Steuerungseinheit (11, 18) ausgelegt ist nicht zum Ausführen der Extraktionsverarbeitung, wenn bestimmt wird, dass eine Zeit eines Motor-Aus-Zeitgebers (17) gleich ist einer oder länger ist als eine spezifizierte Zeit bei dem Start des Verbrennungsmotors.

4. Steuerungsvorrichtung nach Anspruch 1, wobei
die Steuerungseinheit (11, 18) ausgelegt ist nicht zum Ausführen der Extraktionsverarbeitung, wenn ein Leerlauf des Verbrennungsmotors stabil ist.

5. Steuerungsvorrichtung nach Anspruch 1, wobei
die Steuerungseinheit (11, 18) ausgelegt ist zum Bestimmen der Verschlechterung der Sekundärbatterie (5), wenn bestimmt wird, dass ein Motor-Ein-Zeitgeber (20) eine vorgeschriebene Zeit überschreitet.

## Revendications

1. Dispositif de commande (10) qui est configuré pour mesurer des valeurs de tension d'une batterie secondaire (5) à des premiers intervalles et extraire la valeur de tension la plus basse des valeurs de tension mesurées à un second intervalle qui est plus long que le premier intervalle, lors d'un démarrage d'un moteur à combustion interne, le dispositif de commande (10) comprenant :
une unité de commande (11, 18) qui est configurée pour :
répéter le traitement d'extraction pour extraire la valeur de tension la plus basse de la pluralité de valeurs de tension mesurées aux premiers intervalles pendant le second intervalle comprenant la pluralité des premiers intervalles à chaque second intervalle, et
spécifier la valeur de tension la plus basse extraite comme étant le point de tension la plus basse de la batterie secondaire (5), et
procéder à un traitement de détermination de détérioration de batterie pour déterminer la détérioration de la batterie secondaire (5) sur la base du fait que le point de tension la plus basse tombe, ou
non, en dessous d'une valeur de seuil, où la batterie secondaire (5) est déterminée comme n'étant pas détériorée si le point de tension la plus basse ne tombe pas en dessous de la valeur de seuil.

2. Dispositif de commande selon la revendication 1, dans lequel :
l'unité de commande (11, 18) est configurée pour calculer une moyenne de plusieurs valeurs de tension successives parmi les plusieurs valeurs de tension mesurées aux premiers intervalles pendant le second intervalle à chaque second intervalle pour spécifier les valeurs moyennes et extraire la valeur moyenne la plus basse parmi les valeurs moyennes spécifiées comme la valeur de tension la plus basse dans le traitement d'extraction.

3. Dispositif de commande selon la revendication 1, dans lequel :
l'unité de commande (11, 18) est configurée pour ne pas exécuter le traitement d'extraction lorsqu'elle détermine que le temps d'une minuterie d'arrêt du moteur (17) est égal ou supérieur à un temps spécifié au démarrage du moteur à combustion interne.

4. Dispositif de commande selon la revendication 1, dans lequel :
l'unité de commande (11, 18) est configurée pour ne pas exécuter le traitement d'extraction lorsque le ralenti du moteur à combustion interne est stable.

5. Dispositif de commande selon la revendication 1, dans lequel :
l'unité de commande (11, 18) est configurée pour déterminer la détérioration de la batterie secondaire (5) lorsqu'elle détermine qu'une minuterie de mise en marche du moteur (20) dépasse un temps prescrit.
